# EUROPÄISCHE PATENTANMELDUNG

(11) **EP 4 497 716 A1**
(43) Veröffentlichungstag der Anmeldung: **29.01.2025**
(21) Anmeldenummer: 23187673.1
(22) Anmeldetag: 25.07.2023
(51) Int. Cl.: B66B 1/30, B66B 1/32

(54) **VERFAHREN ZUR UMRICHTERÜBERWACHUNG BEZÜGLICH DER FUNKTIONSWEISE EINES BREMSWIDERSTANDSKREISES EINES AUFZUGSYSTEMS SOWIE ENTSPRECHENDES COMPUTERPROGRAMMPRODUKT UND VERWENDUNG, SPANNUNGSVERLAUFSAUSWERTEVORRICHTUNG UND AUFZUGSYSTEM**

(71) Anmelder: TK Elevator Innovation and Operations GmbH, 40472 Düsseldorf (DE)
(72) Erfinder: Nägele, Roland, 70597 Stuttgart (DE); Eberhard, Vogler, 73765 Neuhausen (DE)
(74) Vertreter: Michalski Hüttermann & Partner Patentanwälte mbB

(57) **Zusammenfassung**

Bei Konzeption und Betrieb von Aufzugsystemen sind hohe Sicherheitsanforderungen zu beachten, insbesondere bezüglich der Funktionsweise eines/des Bremswiderstandskreises. Bereitgestellt wird ein Verfahren zur Umrichterüberwachung bezüglich der Funktionsweise eines Bremswiderstandskreises eines Aufzugsystems umfassend wenigstens eine Aufzugskabine und wenigstens einen Umrichter und wenigstens einen Motor, wobei ein Spannungsmonitoring zum Erkennen von Spannungsänderungen erfolgt, wobei wenigstens ein Bremswiderstand über einen Zwischenkreis mit dem Umrichter verschaltet ist; erfindungsgemäß erfolgt zur Umrichterüberwachung ein wiederkehrendes Aktivieren und/oder Abschalten wenigstens einer elektronischen Komponente, wobei durch Auswertung des sich in Reaktion auf das Aktivieren und/oder Abschalten einstellenden Verlaufs der Spannung wenigstens ein fehlerhafter Betriebszustand erkannt oder wenigstens ein ordnungsgemäßer Betriebszustand festgestellt wird. Hierdurch kann auch auf zusätzliche Sensorik verzichtet werden. Die vorliegende Erfindung betrifft dabei auch ein entsprechendes Computerprogrammprodukt, die Verwendung elektrotechnischer Schaltungsanordnungen, die mit solchen Bremswiderstandskreisen interagieren oder Bestandteil dessen sind, sowie eine entsprechende Spannungsverlaufsauswertevorrichtung und ein damit ausgestattetes Aufzugsystem.

## Beschreibung

### TECHNISCHES GEBIET

Die vorliegende Erfindung betrifft ein Verfahren zur Umrichterüberwachung bezüglich der Funktionsweise eines Bremswiderstandskreises eines Aufzugsystems umfassend wenigstens eine Aufzugskabine und wenigstens einen Umrichter und wenigstens einen Motor, der über einen Umrichter mit (Gleichspannungs-)Zwischenkreis mit wenigstens einem Bremswiderstand verschaltet ist, wobei ein Spannungsmonitoring zum Erkennen von Spannungsänderungen erfolgt. Ferner betrifft die vorliegende Erfindung eine diesbezüglich eingerichtete Spannungsverlaufsauswertevorrichtung und ein Aufzugsystem umfassend eine solche Spannungsverlaufsauswertevorrichtung. Nicht zuletzt betrifft die vorliegende Erfindung auch ein entsprechendes Computerprogrammprodukt und entsprechende Verwendungen elektrotechnischer Schaltungsanordnungen, die mit solchen Bremswiderstandskreisen interagieren oder Bestandteil dessen sind. Insbesondere betrifft die Erfindung Verfahren und Vorrichtungen gemäß dem Oberbegriff des jeweiligen unabhängigen Anspruchs.

### HINTERGRUND DER ERFINDUNG

Bei der Konzeption und dem Betrieb von Aufzugsystemen bzw. Aufzuganlagen sind hohe Sicherheitsanforderungen zu beachten, insbesondere unterteilt in vier Level, wobei ein jeweiliges (Ausfall-)Risiko auch basierend auf Wahrscheinlichkeits-Analysen gewichtet werden kann. Bei Aufzugsantrieben, in welchen ein Motor auch eine Bremsfunktion übernimmt, sind die Anforderungen besonders hoch, insbesondere was die Sicherheit bzw. Robustheit eines/des Bremswiderstandskreises betrifft. Insbesondere bei nicht rückspeisefähigen Umrichtern können Fehler im Bremswiderstandskreis zu gefährlichen Situationen insbesondere in Aufzuganlagen führen. Zusätzliche Geräte wie Temperatursensoren können den Bremswiderstand überwachen und einige, aber nicht alle Ausfälle signalisieren.

Gemäß dem Stand der Technik erfolgt beispielsweise ein Abschalten des Umrichters nach jeder Fahrt und eine Kontrolle der Aufladezeit des Zwischenkreises vor der nächsten Fahrt. Beispielsweise wird auch eine Temperaturüberwachung implementiert. Beispielsweise ist/sind wenigstens eine Schmelzsicherung und/oder ein Motorenschutzschalter und/oder ein Überstromrelais vorgesehen.

Ausgehend vom Stand der Technik ist ein Bedarf an einer besonders robusten Fehlerdiagnose und nicht zuletzt auch pragmatischeren Lösungen hinsichtlich der Art und Weise der Implementierung der Diagnose zu spüren. Insbesondere besteht Interesse an einer verbesserten Überwachung, die möglichst robust und mittels einfacher technischer Mittel implementierbar ist und dabei gleichwohl auch ein breites Spektrum an potentiellen Fehlern diagnostizieren bzw. erkennen kann.

### ZUSAMMENFASSUNG DER ERFINDUNG

Aufgabe ist, ein Verfahren und eine Auswertevorrichtung bereitzustellen, womit Fehler in einem Bremswiderstandskreis von Aufzugsystemen auf möglichst robuste sowie auch umfassende und pragmatische und nicht zuletzt auch kosteneffiziente Weise erkannt werden können. Auch ist es Aufgabe, eine solche Fehlererkennung derart implementierbar auszugestalten, dass bei zu erwartenden Risiken oder Gefahren wenigstens eine Gegenmaßnahme realisierbar ist. Nicht zuletzt ist es Aufgabe, eine Fehlererkennung bezüglich der Funktionsweise eines Bremswiderstandskreises eines Aufzugsystems derart auszugestalten, dass die Diagnose möglichst unmittelbar bzw. direkt im Zusammenhang mit vergleichsweise einfach zu messenden Betriebsparametern oder -größen erfolgen kann.

Diese Aufgabe wird durch ein Verfahren gemäß Anspruch 1 sowie durch eine Spannungsverlaufsauswertevorrichtung und ein Aufzugsystem jeweils gemäß dem nebengeordneten Vorrichtungsanspruch sowie durch ein entsprechendes Computerprogrammprodukt und entsprechende Verwendungen elektrotechnischer Schaltungsanordnungen jeweils gemäß dem entsprechenden nebengeordneten Anspruch gelöst. Vorteilhafte Weiterbildungen der Erfindung werden in den jeweiligen Unteransprüchen erläutert. Die Merkmale der im Folgenden beschriebenen Ausführungsbeispiele sind miteinander kombinierbar, sofern dies nicht explizit verneint ist.

Bereitgestellt wird ein Verfahren zur Umrichterüberwachung bezüglich der Funktionsweise eines Bremswiderstandskreises eines Aufzugsystems umfassend wenigstens eine Aufzugskabine und wenigstens einen Umrichter und wenigstens einen Motor, der über einen Umrichter mit Zwischenkreis mit wenigstens einem Bremswiderstand verschaltet ist, wobei ein Spannungsmonitoring zum Erkennen von (außer-/planmäßigen) Spannungsänderungen erfolgt;
Erfindungsgemäß wird vorgeschlagen, dass zur Umrichterüberwachung ein wiederkehrendes, bevorzugt regelmäßiges (intervallisches) Aktivieren und/oder Abschalten wenigstens einer im Bremswiderstandskreis wirkenden oder mit dem Bremswiderstandskreis zusammenwirkenden elektronischen Komponente erfolgt, wobei das Spannungsmonitoring bezüglich des Bremswiderstandskreises in Abhängigkeit vom Aktivieren und/oder Abschalten erfolgt, wobei bzw. indem durch Auswertung des sich in Reaktion auf das Aktivieren und/oder Abschalten der wenigstens einen elektronischen Komponente einstellenden Verlaufs der Spannung wenigstens ein fehlerhafter Betriebszustand erkannt oder wenigstens ein ordnungsgemäßer Betriebszustand festgestellt wird. Dies ermöglicht auch eine robuste Fehlerüberwachung mittels der elektronischen Komponente, wobei die elektronische Komponente bevorzugt eine elektronische Komponente des Bremswiderstandskreises ist.

Das wiederkehrende, bevorzugt regelmäßige Aktivieren und/oder Abschalten der wenigstens einen mit dem Bremswiderstandskreis interagierenden bzw. im Bremswiderstandskreis wirkenden elektronischen Komponente kann dabei insbesondere mittels einer elektrotechnischen Schaltungsanordnung erfolgen, welche z.B. in den Umrichter oder z.B. in den Bremswiderstandskreis integriert ist oder damit interagiert. Die elektrotechnische Schaltungsanordnung ist eingerichtet zum wiederkehrenden Aktivieren bzw. Schalten der entsprechenden elektronischen Komponente für eine vordefinierbare Zeitdauer bzw. in einem vordefinierbaren Intervall, z.B. jeweils für einige Millisekunden. Die elektrotechnische Schaltungsanordnung kann die wenigstens eine elektronische Komponente auch umfassen. Die elektrotechnische Schaltungsanordnung kann dabei auch eingerichtet sein, den Bremswiderstand zu schalten, z.B. mittels IGBT.

Als "eine im Bremswiderstandskreis wirkende oder mit dem Bremswiderstandskreis zusammenwirkende elektronische Komponente" ist gemäß der vorliegenden Offenbarung insbesondere eine im Umrichter bzw. im Bremswiderstandskreis vorliegende elektronische Komponente zu verstehen, insbesondere Chopper oder Sanftanlaufeinrichtung.

Mit anderen Worten: Die vorliegende Erfindung realisiert eine Umrichterüberwachung hinsichtlich tatsächlicher oder zumindest potentieller bzw. zukünftig zu erwartender Fehler im Bremswiderstandskreis eines Aufzugsystems. Dabei kommt dem Bremswiderstand auch eine hohe/wichtige Sicherheitsfunktion zu, insbesondere dann wenn der Bremswiderstand im Wesentlichen für ein Abbremsen einer/der Aufzugskabine genutzt werden soll. Die vorliegende Erfindung basiert dabei auf dem Konzept, durch den Einsatz vorhandener Mittel wie z.B. eines/des Choppers bzw. eines/des Chopper-Transistors oder einer/der Sanftanlaufeinrichtung tatsächliche bzw. potentielle Fehler und weitere Ausfälle ohne zusätzliche Sensorik oder Überwachungsmittel zu erkennen. Auf diese Weise kann auch die Sicherheit beim Betrieb des Aufzugsystems spürbar erhöht werden, insbesondere ohne zusätzliche Kosten, gegebenenfalls sogar bei spürbarem Kosteneinsparpotential.

Beispielsweise können mittels der erfindungsgemäßen Maßnahme die folgenden Fehler in der Bremswiderstandsschaltung erkannt und geeignete Gegenmaßnahmen ausgelöst werden:
- dauerhaft leitender Chopper-Transistor aufgrund von Fehlern im Chopper-Treiberteil oder aufgrund eines Kurzschlusses im Chopper selbst;
- Erdschluss in der Verbindung zwischen Chopper und Bremswiderstand;
- Erdschluss im Bremswiderstand;

Beispiel: Wenn der Umrichter eingeschaltet ist, aber keinen angeschlossenen Motor antreibt, liegt am Zwischenkreis eine Dauerspannung an (Chopper-Transistor abgeschaltet). Insbesondere die oben genannten Fehler können zu einem Dauerstrom im Bremswiderstand führen, ohne dass dieser mittels der bisher im Stand der Technik verfügbaren Lösungen erkannt werden kann. Dies kann zu einer hohen Temperatur des Bremswiderstands und seiner Umgebung und insbesondere auch zu einem permanenten Energieverlust führen. Demgegenüber ermöglicht die vorliegende Erfindung, derartige Fehler mit guter Sicherheit bzw. Robustheit zu erkennen, insbesondere mittels bereits im Bremswiderstandskreis vorhandener elektronischer Mittel/Komponenten, und wahlweise auch geeignete Gegenmaßnahmen einzuleiten.

Im Aufzugsbetrieb wird der Motor bei vielen standardmäßigen Implementierungen bei jeder Fahrt eingeschaltet und beim Anhalten des Aufzugs ausgeschaltet. Während der Motor abgeschaltet ist, bleibt der Umrichter üblicherweise eingeschaltet, insbesondere auch zur Geräuschdämpfung zugehöriger Schütze.

Mittels der erfindungsgemäßen Maßnahmen können derartige Fehler auf einfache und robuste Weise nicht nur erkannt werden, sondern es können auch entsprechend geeignete Gegenmaßnahmen implementiert sein/werden.

Beispielsweise erfolgt die Implementierung der Erfindung derart, dass zumindest eine regelmäßige Aktivierung eines/des Choppers für einige Millisekunden während des Leerlaufs erfolgt. Wenn kein Fehler auftritt, fällt die Zwischenkreisspannung leicht ab. Dieser Spannungsabfall kann durch die normale DC-Spannungsüberwachung erkannt werden und signalisiert, dass kein Fehler vorliegt. Im Falle eines der oben beschriebenen Fehler ist der Bremswiderstand ganz oder teilweise dauerhaft eingeschaltet und die Spannung ist noch abgesunken. Das zusätzliche Einschalten des Choppers führt nicht zu einem nennenswerten Spannungsabfall, der auf einen möglichen Fehler hinweist.

Beispielsweise erfolgt die Implementierung der Erfindung derart, dass zumindest ein regelmäßiges Abschalten einer/der Sanftanlaufeinrichtung des Umrichters für einige Millisekunden im Leerlaufbetrieb erfolgt. Wenn kein Fehler auftritt, wird keine Energie aus dem Zwischenkreis abgegeben. Das Abschalten der Sanftanlaufeinrichtung hat nur geringe Auswirkungen auf die Zwischenkreisspannung. Im Falle eines der oben beschriebenen Ausfälle versorgt der Zwischenkreis den Bremswiderstand. Wenn die Sanftanlaufeinrichtung abgeschaltet wird, sinkt die Zwischenkreisspannung aufgrund der Leistungsaufnahme des unbeabsichtigt angesteuerten Bremswiderstands. Die Gleichspannungsüberwachung erkennt den Spannungsabfall, und dessen Auswertung erlaubt, einen Hinweis auf einen möglichen Fehler zu generieren.

Es ist zu verstehen, dass das Schalten bzw. Aktivieren vorteilhaft im 1- bis 2-stelligen Millisekunden-Bereich eingestellt bzw. vorgegeben ist/wird. Dabei kann dieselbe Dauer bzw. dasselbe Intervall für die hier beschriebenen unterschiedlichen elektronischen Komponenten vorgesehen sein, insbesondere für Chopper und Sanftanlaufeinrichtung.

Die vorliegende Erfindung liefert hohes Kosteneinsparpotential (insbesondere auch da keine zusätzlichen Geräte erforderlich sind) und ermöglicht auch, zahlenmäßig mehr potentielle Fehler zu detektieren. Anders ausgedrückt: Bei erfindungsgemäßer Implementierung werden mehr mögliche Ausfälle erkannt/identifiziert/detektiert. Beispielsweise kann mittels der vorliegenden Erfindung ein abnormaler Temperaturanstieg des Bremswiderstands verhindert werden, z.B. im Zusammenhang mit einem Ausschalten des Aufzugs; dies trägt nicht zuletzt auch zu sehr sicherem Betriebsverhalten bei. Weitere Kostenvorteile ergeben sich z.B. dadurch, dass Kosten z.B. für Temperatursensoren am Bremswiderstand (Sensor, Verkabelung, Aderendhülsen, Klemmen, Zeit für die Montage, und dergleichen) reduziert oder sogar vollständig eingespart werden können.

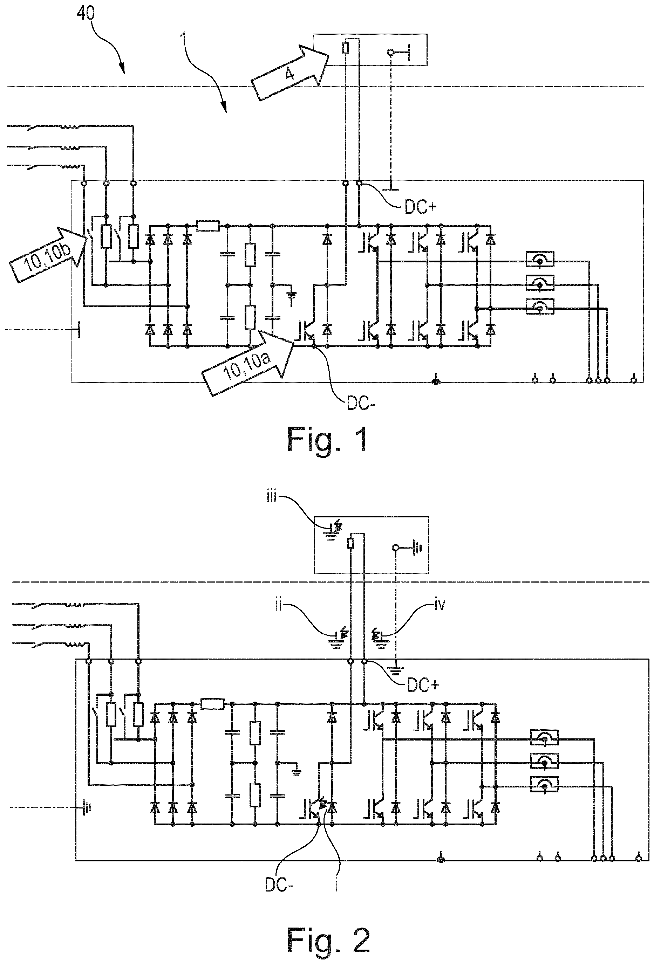

Die vorliegende Erfindung kann beispielsweise auch im Kontext wenigstens eines der folgenden Szenarien vorteilhaft implementiert sein/werden, wie auch in Fig. 2 veranschaulicht:
Fall i): es liegt ein Kurzschluss an einem/dem IGBT vor (insbesondere Kollektor/Emitter);
Fall ii): es liegt ein Erdschluss bezüglich des Bremswiderstands vor (insbesondere dynamischer Bremswiderstand DBR, Anschluss IGBT Transistor zum Schalten des Bremswiderstands);
Fall iii): es liegt ein Erdschluss bezüglich des Bremswiderstands als solchem vor (DBR intern);
Fall iv): es liegt ein Erdschluss bezüglich des Anschlusses DC+ des Bremswiderstands (DBR) vor;

In diesem Zusammenhang liefert die vorliegende Erfindung insbesondere auch bezüglich Fall ii den Vorteil höherer Betriebssicherheit. Die einzelnen Szenarien können dabei auch im Zusammenhang den folgenden durch Schlagwortüberschriften zusammengefassten Betriebszuständen relevant werden: treibender Betrieb des Aufzugs (Normalfahrt, Nachstellen bei geöffneten Türen), Standby, generatorischer Betrieb des Aufzugs (Normalfahrt, Nachstellen bei geöffneten Türen).

Die vorliegende Erfindung ermöglicht beispielsweise im Zusammenhang mit den folgenden Randbedingungen und Gefahren bzw. Risiken einen noch sichereren Betrieb des Aufzugsystems: hohe Auslastung in zugmittelbasierten Aufzugsystemen, große abzubremsende Geschwindigkeiten, hohe Brandschutzanforderungen.

Die vorliegende Erfindung kann z.B. auch im Zusammenhang mit den folgenden zum Teil durch Richtlinien oder Normen vorgegebenen (Sicherheits-)Funktionen implementiert sein/werden, wobei die Überwachung auch bei/nach Auftreten einer der betrachteten Fehlerfälle aktiv bleiben kann:
- Überwachung hinsichtlich Über- und Unterspannung, insbesondere durch den Umrichter selbst;
- Übergeschwindigkeitsüberwachung durch Steuerungs-/Regelungseinrichtung;
- Überwachung der Sollgeschwindigkeit, insbesondere auch Schleppfehlerüberwachung, insbesondere durch Vergleich von Soll-Ist-Werten durch Steuerung, insbesondere einschließlich Schlauchüberwachung, insbesondere auch Überwachung bei überbrücktem Türsicherheitskreis;
- Motorlaufzeitüberwachung;
- elektrische Vorabschaltung Geschwindigkeitsbegrenzer;
- Sicherheitskreis mit sicherer Brems- und Motorabschaltung;

Die vorliegende Erfindung erlaubt nicht zuletzt auch ein sehr hohes Sicherheitsniveau, insbesondere in Hinblick auf ein sicheres Abschalten von sicherheitsrelevanten Komponenten im Falle eines diagnostizierten Fehlers oder eines sich potentiell einstellenden Fehlers, der zu einer Fehlfunktion des Aufzugsystems führen kann.

Es ist zu verstehen, dass die vorliegende Erfindung bereits zumindest im Wesentlichen im Rahmen einer Implementierung des hier beschriebenen Schaltens und Auswertens realisiert werden kann. Anders ausgedrückt: Eine (vorrichtungstechnische) Abänderung oder Erweiterung einer bewährten Schaltungsanordnung ist nicht notwendigerweise erforderlich, um die hier beschriebene Erfindung realisieren zu können. Wahlweise kann die hier beschriebene Erfindung auch in Ergänzung zu einer bereits vorhandenen sensorischen Überwachung, insbesondere Temperaturüberwachung betreffend den Bremswiderstand, implementiert sein/werden. Des Weiteren ist zu verstehen, dass die vorliegende Erfindung auch alternativ oder in Ergänzung zu den folgenden beiden Überwachungsoptionen implementiert sein/werden kann: Überwachen der für das Laden des Zwischenkreises auf volle Spannung beim Einschalten des Umrichters erforderlichen Zeit (im Leerlauf muss/müsste der Umrichter ausgeschaltet werden); und/oder permanente Überwachung der Temperatur zumindest des Bremswiderstandes.

Auch ist zu verstehen, dass die vorliegende Erfindung vorteilhaft im Zusammenhang mit Antrieben bzw. Motoren für Aufzugskabinen implementiert werden kann, welche mittels Zugmitteln verlagert/verlagerbar sind. Das jeweilige Aufzugsystem kann dabei wahlweise auch seillos betriebene Aufzugskabinen umfassen, insoweit also auch als ein aus diesen unterschiedlichen Antriebsarten kombiniertes System ausgestaltet sein.

Nicht zuletzt ist zu verstehen, dass die vorliegende Erfindung auch vorteilhaft im Einklang mit bereits bestehenden Normen und etwaigen zukünftigen Regeln und Normen realisiert werden kann, insbesondere da für viele Anwendungen zwar eine Überwachung der Temperatur zumindest des Bremswiderstands als zwingend notwendig vorausgesetzt wird, nicht jedoch vorgegeben wird, dass die Temperatur mittels Temperatursensorik überwacht werden muss. Die vorliegende Erfindung ermöglicht eine indirekte Überwachung der Temperatur zumindest des Bremswiderstands durch Bezugnahme auf (abnormale) Spannungsänderungen; insoweit kann eine bestimmte abnorme Spannungsverlaufsabweichung auch mit einer unzulässig hohen Temperatur oder einem entsprechend steilen Temperaturanstieg im Rahmen der vorliegenden Erfindung korreliert sein/werden.

Personifizierte Begriffe, soweit sie hier nicht im Neutrum formuliert sind, können im Rahmen der vorliegenden Offenbarung alle Geschlechter betreffen. Etwaige hier verwendete englischsprachige Ausdrücke oder Abkürzungen sind jeweils branchenübliche Fachausdrücke und sind dem Fachmann in englischer Sprache geläufig. Etwaige dazu synonym verwendete/verwendbare deutschsprachige Begriffe können hier der Vollständigkeit halber in (Klammern) angegeben werden, oder vice versa, beispielsweise bezüglich des Begriffs Chopper (Zerhacker) oder soft start device (Sanftanlaufeinrichtung).

Gemäß einem Ausführungsbeispiel wird beim Aktivieren oder Abschalten einer ersten elektronischen Komponente ein in Reaktion darauf nicht erfolgender Spanungsabfall (kein sinkender Spannungsverlauf) als Fehler diagnostiziert/definiert. Diese Art und Weise einer/der Implementierung erleichtert die Überwachung bzw. Diagnose insbesondere im Zusammenhang mit der Funktionsweise der Schnittstelle zum Zwischenkreis, insbesondere bezüglich eines Schaltenvorgangs eines/des Choppers.

Gemäß einem Ausführungsbeispiel wird beim Aktivieren oder Abschalten einer zweiten elektronischen Komponente ein in Reaktion darauf erfolgender Spanungsabfall (sinkender Spannungsverlauf) als Fehler diagnostiziert/definiert. Diese Art und Weise einer/der Implementierung erleichtert die Überwachung bzw. Diagnose insbesondere im Zusammenhang mit einer potentiellen fehlerhaften Energieabgabe aus dem Zwischenkreis an den Bremswiderstand, insbesondere bezüglich eines Schaltenvorgangs einer/der Sanftanlaufeinrichtung.

Es ist zu verstehen, dass ein/das Aktivieren oder Abschalten einer/der ersten elektronischen Komponente unabhängig davon implementiert sein/werden kann, ob/wann ein/das Aktivieren oder Abschalten einer/der zweiten elektronischen Komponente erfolgt, und vice versa. Insbesondere kann der Fachmann für den jeweiligen Anwendungsfall vorgeben, ob ein intervallisches Aktivieren/Abschalten von Chopper und/oder Sanftanlaufeinrichtung erfolgen soll. Das Spannungsmonitoring kann für alle drei Varianten implementiert sein/werden (Aktivieren/Abschalten ausschließlich von Chopper, Aktivieren/Abschalten ausschließlich von Sanftanlaufeinrichtung, Aktivieren/Abschalten sowohl von Chopper als auch von Sanftanlaufeinrichtung).

Gemäß einem Ausführungsbeispiel wird als erste elektronische Komponente ein Chopper-Transistor verwendet, welcher wiederkehrend aktiviert wird, insbesondere für einige Millisekunden im Leerlauf.

Gemäß einem Ausführungsbeispiel wird als zweite elektronische Komponente eine Sanftanlaufeinrichtung des wenigstens einen Umrichters verwendet, welcher wiederkehrend abgeschaltet wird, insbesondere für einige Millisekunden im Leerlauf. Dies ermöglicht jeweils auch eine wiederkehrende Überprüfung hinsichtlich potentieller Fehler, ohne dafür weitere Sensorik oder dergleichen zusätzliche Diagnosemittel implementieren zu müssen.

Gemäß einem Ausführungsbeispiel erfolgt das Aktivieren oder Abschalten jeweils für einige Millisekunden im Leerlauf, z.B. alle drei oder alle zehn Minuten. Es hat sich gezeigt, dass diese Zeitspanne ausreicht, um die ordnungsgemäße Betriebsfunktion mit guter Sicherheit überprüfen zu können. Vorteilhaft ist dabei ein Intervall im Bereich von z.B. einer Minute, oder einigen Minuten (z.B. fünf oder fünfzehn Minuten). Der Fachmann kann je nach gewünschter Implementierung z.B. auch in Abhängigkeit von etwaigen weiteren Diagnosemöglichkeiten wie z.B. einer Temperaturmessung entscheiden, ob es sinnvoll ist, das (Ab-)Schalten/Aktivieren bereits nach wenigen Minuten zu wiederholen, oder ein vergleichsweise langes Intervall von z.B. vielen im zweistelligen Minutenbereich zu wählen.

Gemäß einem Ausführungsbeispiel umfasst das Spannungsmonitoring eine Gleichspannungsüberwachung. Diese ist vorteilhaft ohnehin im Zwischenkreis implementiert bzw. dafür bereits vorgesehen und kann vorteilhaft auch im Zusammenhang mit der erfindungsgemäßen Diagnose genutzt werden.

Beispielsweise ist der wenigstens eine Umrichter ein nicht rückspeisefähiger Umrichter. Eine Anordnung mit Gleichspannungszwischenkreis hat sich insbesondere im Zusammenhang mit den hier beschriebenen Aufzugsystemen und Aufzugsystemkomponenten als besonders zweckdienlich erwiesen. Es ist zu verstehen, dass die vorliegende Erfindung für Aufzugsysteme allgemein im Kontext mit Umrichtern im Allgemeinen implementiert werden kann, d.h., der jeweilige Umrichtertyp wirkt sich nicht einschränkend auf das hier beschriebene Spannungsmonitoring aus.

Gemäß einem Ausführungsbeispiel wird durch Auswertung des Verlaufs der Spannung wenigstens ein fehlerhafter Betriebszustand aus der folgenden Gruppe festgestellt und ein damit korreliertes Fehlersignal generiert: dauerhaft leitender Chopper insbesondere aufgrund von fehlerhaftem Chopper-Treiber oder eines Kurzschlusses im Chopper, (fehlerhafter) Erdschluss in der Verbindung zwischen Chopper und Bremswiderstand, (fehlerhafter) Erdschluss im Bremswiderstand. Dieser Diagnoseumfang kann dabei erfindungsgemäß mittels elektronischer Komponenten des Umrichters bzw. des Bremswiderstandskreises sichergestellt werden.

Es ist zu verstehen, dass die hier beschriebenen Fehler sowohl über das (Ab-)Schalten bzw. Aktivieren des Choppers als auch über das (Ab-)Schalten bzw. Aktivieren der Sanftanlaufeinrichtung diagnostiziert werden können. Diese beiden Vorgänge können dabei auch als gleichrangig erachtet werden.

Gemäß einem Ausführungsbeispiel ist/wird eine vordefinierte Spannungsänderung derart mit einer Änderung der Temperatur des Bremswiderstands korreliert, insbesondere durch entsprechende Hinterlegung einer Abhängigkeit in einem Datenspeicher einer/der Spannungsverlaufsauswertevorrichtung, dass eine indirekte Überwachung der Temperatur zumindest des Bremswiderstands durch Korrelation mit der gemessenen Spannungsänderungen detektierbar ist bzw. detektiert wird. Insoweit kann eine bestimmte abnorme Spannungsverlaufsabweichung auch mit einer unzulässig hohen Temperatur oder einem entsprechend steilen Temperaturanstieg im Rahmen der vorliegenden Erfindung korreliert sein/werden. Dies erleichtert nicht zuletzt auch einen mit etwaigen Vorgaben durch Normen oder Richtlinien konformen vollständigen Verzicht auf eine sensorische Temperaturüberwachung.

Die zuvor genannte Aufgabe wird auch gelöst durch ein Verfahren zum Steuern/Regeln eines Aufzugsystems basierend auf einem/dem hier offenbarten Verfahren zur Umrichterüberwachung, wobei das Aufzugsystem oder zumindest wenigstens eine Aufzugskabine des Aufzugsystems oder eine antriebsbezogene Komponente betreffend wenigstens eine Aufzugskabine des Aufzugsystems (also auch eine die Bremsfunktion betreffende Komponente) in Reaktion auf ein Diagnostizieren/Definieren des wenigstens einen Fehlers (aus-)geschaltet wird, insbesondere mittels einer Steuerungs-/Regelungseinrichtung des Aufzugsystems. Dies erleichtert nicht zuletzt auch die Implementierung einer Sicherheitsmaßnahme direkt im Zusammenhang mit dem Betrieb von Aufzugssystemen.

Gemäß einem Ausführungsbeispiel wird das Verfahren bei weiterhin eingeschaltetem Umrichter und bereits ausgeschaltetem Motor (Motor im Standby bzw. System im Leerlauf) ausgeführt, wobei das Ausschalten derart erfolgt, dass ein Dauerstrom im Bremswiderstand vermieden wird. Dies kann auch den Betrieb des Aufzugsystems noch sicherer ausgestalten.

Die zuvor genannte Aufgabe wird auch gelöst durch ein Computerprogrammprodukt umfassend Befehle, die bei Ausführung des Computerprogrammproduktes auf einem Computer diesen dazu veranlassen, ein Verfahren zur Umrichterüberwachung gemäß der vorliegenden Offenbarung auf dem Computer bzw. mittels des Computers auszuführen, insbesondere Computerprogrammprodukt eingerichtet zum Generieren einer Steuerungs-/Regelungsvorgabe für ein/das Aufzugsystem in Abhängigkeit vom Diagnostizieren wenigstens eines Fehlers im Bremswiderstandskreis. Anders ausgedrückt: Vorteilhaft erfolgt nicht nur eine Überwachung mittels des Computerprogrammproduktes, sondern auch das Generieren einer Steuerungs-/Regelungsvorgabe insbesondere für eine Steuerungs-/Regelungseinrichtung des Aufzugsystems. Dies ermöglicht basierend auf den zuvor genannten Vorteilen z.B. auch das Nachrüsten des hier beschriebenen Funktionsumfangs für bereits im Feld installierte Systeme. Dabei ist zu verstehen, dass die vorliegende Erfindung bereits zumindest im Wesentlichen im Rahmen einer computerimplementierten Umsetzung realisiert werden kann. Anders ausgedrückt: Eine vorrichtungstechnische Erweiterung/Ergänzung ist nicht notwendigerweise erforderlich. Wahlweise kann auch eine Temperaturmessung bei der Auswertung zusätzlich mit berücksichtigt werden, z.B. im Rahmen einer Plausibilitätsprüfung oder eines zusätzlichen Abgleichs mehrerer Diagnoseergebnisse untereinander. Die jeweilige Steuerungs-/Regelungsvorgabe kann auch eine Vorgabe sein, welche eine Betriebsweise wenigstens einer Sicherheitseinrichtung wie z.B. einer Fangbremse oder dergleichen vorgibt.

Die zuvor genannte Aufgabe wird auch gelöst durch Verwendung einer elektrotechnischen Schaltungsanordnung eingerichtet zum wiederkehrenden Aktivieren und/oder (An-/Ab-)Schalten wenigstens einer mit einem Bremswiderstandskreis eines Aufzugsystems interagierenden oder im Bremswiderstandskreis wirkenden elektronischen Komponente aus der Gruppe Chopper bzw. Chopper-Transistor und Sanftanlaufeinrichtung zum Überwachen der Funktionsweise eines Bremswiderstandskreises des Aufzugsystems, wobei ein Spannungsmonitoring bezüglich des Bremswiderstandskreises in Abhängigkeit vom Aktivieren und/oder Schalten erfolgt, wobei durch Auswerten des sich in Reaktion auf das Aktivieren und/oder Schalten der wenigstens einen elektronischen Komponente einstellenden Verlaufs der Spannung wenigstens ein fehlerhafter Betriebszustand erkannt oder wenigstens ein ordnungsgemäßer Betriebszustand festgestellt wird, insbesondere bei einem Verfahren zur Umrichterüberwachung gemäß der vorliegenden Offenbarung. Hierdurch lassen sich zuvor genannte Vorteile realisieren, insbesondere in Hinblick auf einen vergleichsweise einfach und kostengünstig implementierbaren Diagnoseprozess basierend auf zumindest teilweise bereits vorhandenen elektronischen/elektrotechnischen Komponenten.

Die zuvor genannte Aufgabe wird auch gelöst durch eine Spannungsverlaufsauswertevorrichtung eingerichtet zur Umrichterüberwachung bezüglich der Funktionsweise eines Bremswiderstandskreises eines Aufzugsystems umfassend wenigstens eine Aufzugskabine und wenigstens einen Umrichter und wenigstens einen Motor, der über einen Umrichter mit Zwischenkreis mit wenigstens einem Bremswiderstand verschaltet ist, wobei ein Spannungsmonitoring zum Erkennen von (außer-/planmäßigen) Spannungsänderungen erfolgt; wobei die Spannungsverlaufsauswertevorrichtung eingerichtet ist, ein Spannungsmonitoring in Abhängigkeit von wiederkehrendem, bevorzugt regelmäßigem (intervallischem) Aktivieren und/oder Abschalten wenigstens einer im Bremswiderstandskreis wirkenden oder mit dem Bremswiderstandskreis zusammenwirkenden elektronischen Komponente vorzunehmen, insbesondere bei wiederkehrendem Aktivieren und/oder (An-/Ab-)Schalten durchgeführt mittels einer elektrotechnischen Schaltungsanordnung, wobei die Spannungsverlaufsauswertevorrichtung eingerichtet ist zum Erkennen wenigstens eines fehlerhaften Betriebszustands oder zum Feststellen wenigstens eines ordnungsgemäßen Betriebszustands durch Auswertung des Verlaufs der Spannung, insbesondere Spannungsverlaufsauswertevorrichtung eingerichtet zum Ausführen eines Verfahrens zur Umrichterüberwachung gemäß der vorliegenden Offenbarung. Hierdurch ergeben sich zuvor genannte Vorteile, insbesondere auch in Hinblick auf eine zweckdienliche Nutzung von zumindest teilweise bereits vorhandener elektronischer/elektrotechnischer Komponenten für (Fehler-)Diagnosezwecke.

Gemäß einer Ausführungsform weist die elektrotechnische Schaltungsanordnung wenigstens eine erste elektronische Komponente in Ausgestaltung als Chopper-Transistor auf, welcher wiederkehrend aktivierbar ist, insbesondere für einige Millisekunden im Leerlauf; und/oder wobei die elektrotechnische Schaltungsanordnung wenigstens eine zweite elektronische Komponente in Ausgestaltung als Sanftanlaufeinrichtung des wenigstens einen Umrichters aufweist, welche wiederkehrend abschaltbar ist, insbesondere für einige Millisekunden im Leerlauf.

Gemäß einer Ausführungsform ist das wiederkehrende Aktivieren und/oder (An-/Ab-)Schalten derart durchführbar, dass beim Aktivieren oder Abschalten einer/der ersten elektronischen Komponente ein in Reaktion darauf nicht erfolgender Spanungsabfall als Fehler diagnostizierbar ist. Das wiederkehrende Aktivieren (An-/Ab-)Schalten kann auch derart durchführbar sein, dass in Reaktion darauf erfolgender Spanungsabfall als Fehler diagnostizierbar ist.

Die zuvor genannte Aufgabe wird auch gelöst durch ein Aufzugsystem umfassend eine Spannungsverlaufsauswertevorrichtung gemäß der vorliegenden Offenbarung, wobei das Aufzugsystem wenigstens eine Aufzugskabine und wenigstens einen Umrichter und wenigstens einen Motor umfasst, der über den Umrichter mit Zwischenkreis mit wenigstens einem Bremswiderstand verschaltet ist. Insbesondere in diesem Zusammenhang lassen sich die zuvor genannten Vorteilen besonders wirkungsvoll implementieren.

Zusammenfassung: Bei der Konzeption und dem Betrieb von Aufzugsystemen sind hohe Sicherheitsanforderungen zu beachten, insbesondere bei Aufzugsantrieben, in welchen ein Motor auch eine Bremsfunktion übernimmt, z.B. bezüglich der Sicherheit eines/des Bremswiderstandskreises. Bereitgestellt wird ein Verfahren zur Umrichterüberwachung bezüglich der Funktionsweise eines Bremswiderstandskreises eines Aufzugsystems umfassend wenigstens eine Aufzugskabine und wenigstens einen Umrichter und wenigstens einen Motor, der über einen Umrichter mit Zwischenkreis mit wenigstens einem Bremswiderstand verschaltet ist, wobei ein Spannungsmonitoring zum Erkennen von Spannungsänderungen erfolgt; erfindungsgemäß erfolgt zur Umrichterüberwachung ein wiederkehrendes Aktivieren und/oder Abschalten wenigstens einer im Bremswiderstandskreis wirkenden oder mit dem Bremswiderstandskreis zusammenwirkenden elektronischen Komponente, wobei durch Auswertung des sich in Reaktion auf das Aktivieren und/oder Abschalten der wenigstens einen elektronischen Komponente einstellenden Verlaufs der Spannung wenigstens ein fehlerhafter Betriebszustand erkannt oder wenigstens ein ordnungsgemäßer Betriebszustand festgestellt wird. Hierdurch kann auch auf zusätzliche Sensorik verzichtet werden. Die vorliegende Erfindung betrifft dabei auch ein entsprechendes Computerprogrammprodukt, die Verwendung elektrotechnischer Schaltungsanordnungen, die mit solchen Bremswiderstandskreisen interagieren oder Bestandteil dessen sind, sowie eine entsprechende Spannungsverlaufsauswertevorrichtung und ein damit ausgestattetes Aufzugsystem.

### KURZE BESCHREIBUNG DER FIGUREN

In den nachfolgenden Zeichnungsfiguren wird die Erfindung noch näher beschrieben, wobei für Bezugszeichen, die nicht explizit in einer jeweiligen Zeichnungsfigur beschrieben werden, auf die anderen Zeichnungsfiguren verwiesen wird. Es zeigen jeweils in schematischer Darstellung:
**Figur 1** eine Anordnung mit einem Bremswiderstandskreis in einer Schaltungsanordnung zum Ausführen eines Verfahrens zur Umrichterüberwachung gemäß Ausführungsbeispielen;
**Figur 2** potentielle Fehlerquellen in einer Anordnung gemäß Fig. 1;
**Figur 3** Komponenten eines Aufzugsystems eingerichtet zum Ausführen eines Verfahrens zur Umrichterüberwachung gemäß Ausführungsbeispielen;
**Figur 4** Schritte und deren Interaktion mit Komponenten zum Ausführen eines Verfahrens zur Umrichterüberwachung gemäß Ausführungsbeispielen;

### DETAILLIERTE BESCHREIBUNG DER FIGUREN

Die Erfindung wird zunächst unter allgemeiner Bezugnahme auf alle Bezugsziffern und Figuren erläutert. Besonderheiten bzw. Einzelaspekte der vorliegenden Erfindung werden im Zusammenhang mit der jeweiligen Figur thematisiert.

Bereitgestellt wird ein Aufzugsystem 100 aufweisend wenigstens eine Aufzugskabine 101, die mittels wenigstens eines Motors 3 verlagerbar ist, wobei der Motor 3 über einen Umrichter 2 mit Zwischenkreis 5 mit wenigstens einem Bremswiderstand 4 bzw. Bremswiderstandskreis 1 verschaltet ist. Wenigstens eine elektronische Komponente 10, korreliert mit Bremswiderstandskreis und/oder Umrichter, ist dabei derart ansteuerbar (insbesondere intervallisch an-/abschaltbar), dass das Spannungsmonitoring bezüglich des Bremswiderstandskreises in Abhängigkeit vom Aktivieren und/oder Abschalten erfolgen kann, wobei durch Auswertung des sich in Reaktion auf das Aktivieren und/oder Abschalten der wenigstens einen elektronischen Komponente einstellenden Verlaufs der Spannung wenigstens ein fehlerhafter Betriebszustand erkannt oder wenigstens ein ordnungsgemäßer Betriebszustand festgestellt werden kann. Die wenigstens eine elektronische Komponente 10 kann dabei als Bestandteil einer elektrotechnischen Schaltungsanordnung 40 bereitgestellt sein, bzw. kann die entsprechende Schaltfunktionalität für die entsprechende elektronische Komponente 10 nachgerüstet implementiert sein/werden. Die wenigstens eine elektronische Komponente 10 umfasst dabei vorteilhaft wenigstens einen Chopper 10a für den Bremswiderstand (Chopper-Transistor, Chopper-Treiberteil) und/oder wenigstens eine Sanftanlaufeinrichtung (soft start device) 10b für den Umrichter, wahlweise zumindest diese beiden Komponenten. Mittels einer Spannungsverlaufsauswertevorrichtung 20 kann das hier beschriebene Spannungsmonitoring durchgeführt und dabei auch lokal oder zentral dokumentiert werden, z.B. indem die Spannungsmesswerte systemspezifisch auf einem zentralen Server abgelegt werden (bevorzugt auf drahtlosem Wege). Dies erleichtert nicht zuletzt auch eine systemspezifische Wartung und Überprüfung z.B. bei Aufzugsystemen mit sehr zahlreichen Motoren. Die Spannungsverlaufsauswertevorrichtung 20 kann eine mit dem Zwischenkreis 5 korrelierte Gleichspannungsüberwachungseinheit 21 umfassen. Eine Steuerungs-/Regelungseinrichtung 30 des Aufzugsystems 100 kann dabei insbesondere auch in Abhängigkeit von gemessenen Spannungswerten ein Steuersignal generieren, bzw. kann das System entsprechend angesteuert werden, z.B. abgeschaltet werden.

Ein Verfahren zur Umrichterüberwachung bezüglich einer/der fehlerfreien Funktionsweise eines Bremswiderstandskreises eines Aufzugsystems kann dabei gemäß Ausführungsbeispielen der Erfindung im Wesentlichen basierend auf vier Schritten realisiert werden: erster Schritt **S1** wiederkehrendes Aktivieren oder Abschalten wenigstens einer im/mit dem Bremswiderstandskreis (zusammen-)wirkenden elektronischen Komponente; zweiter Schritt **S2** Spannungsmonitoring durch Spannungsverlaufsauswertung, insbesondere umfassend Schritt **S2a** Fehler diagnostizieren bei nicht erfolgendem Spanungsabfall im Zwischenkreis in Reaktion auf Aktivieren des Choppers und/oder umfassend Schritt **S2b** Fehler diagnostizieren bei erfolgendem Spanungsabfall im Zwischenkreis in Reaktion auf Abschalten der Sanftanlaufeinrichtung; dritter Schritt **S3** Generieren eines Fehlersignals; vierter Schritt **S4** (Ab-)Schalten wenigstens einer antriebsbezogenen Komponente;
In **Fig. 1** ist ein Bremswiderstandskreis 1 gezeigt, bei welchem ein Umrichter mit Zwischenkreis wenigstens einen Bremswiderstand 4 mit einem Motor verschaltet. Die hier beschriebene elektrotechnische Schaltungsanordnung 40 umfasst dabei wenigstens eine wiederkehrend aktivierbare/abschaltbare elektronische Komponente aus der Gruppe Chopper(-Transistor) und Sanftanlaufeinrichtung.

In **Fig. 2** sind beispielhaft potentielle Fehlerquellen in einer/der in Fig. 1 gezeigten Anordnung illustriert:
Fall i): Kurzschluss an IGBT;
Fall ii): Erdschluss bezüglich Bremswiderstand Anschluss IGBT;
Fall iii): Erdschluss bezüglich Bremswiderstand als solchem;
Fall iv): Erdschluss bezüglich Anschluss DC+ des Bremswiderstands;
Dabei kann z.B. ein IGBT als Transistor zum Schalten des Bremswiderstands (DBR Dynamic Braking Resistor) zum Einsatz kommen. Der IGBT kann Bestandteil der hier beschriebenen Schaltungsanordnung sein. Als DC+ ist dabei der Pluspol des Zwischenkreises (Potential gegenüber Erde: ca. +50 % der Zwischenkreisspannung) zu verstehen, und als DC- ist der Minuspol des Zwischenkreises (Potential gegenüber Erde: ca. -50 % der Zwischenkreisspannung) zu verstehen.

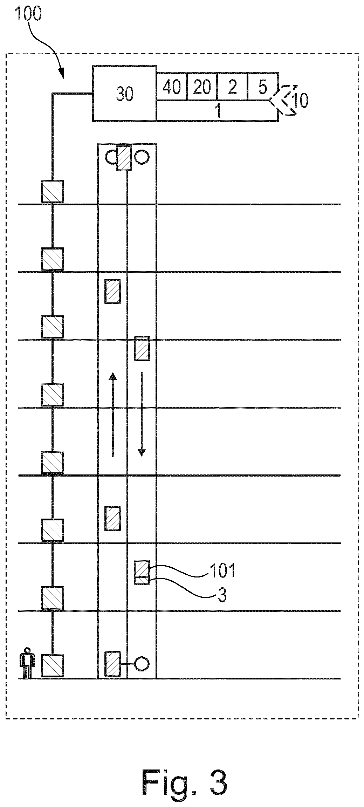

In **Fig. 3** ist ein Aufzugsystem 100 gezeigt, bei welchem mittels Zugmitteln verlagerte/verlagerbare Aufzugskabinen mittels wenigstens eines Motors 3 angetrieben und auch abgebremst werden können. Das Aufzugsystem kann dabei wahlweise sowohl seillos betriebene Aufzugskabinen als auch mittels Zugmitteln verlagerte Aufzugskabinen umfassen, insoweit also auch als ein aus diesen unterschiedlichen Antriebsarten kombiniertes System ausgestaltet sein.

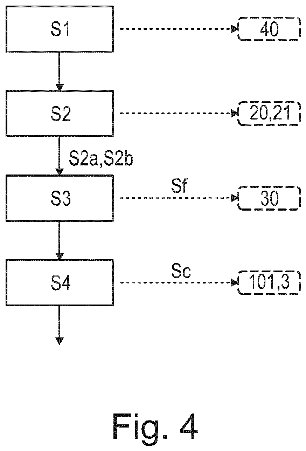

In **Fig. 4** ist eine beispielhafte Korrelation zwischen den hier beschriebenen Verfahrensschritten und Komponenten des Aufzugsystems veranschaulicht. Im Zusammenhang mit Schritt S3 kann ein Fehlersignal Sf generiert und entsprechend transmittiert/weitergeleitet werden, und im Zusammenhang mit Schritt S4 kann ein Steuersignal Sc generiert und entsprechend transmittiert/weitergeleitet werden.

### Bezugszeichenliste

- 1: Bremswiderstandskreis
- 2: Umrichter
- 3: Motor
- 4: Bremswiderstand
- 5: Zwischenkreis
- 10: mit dem Bremswiderstandskreis zusammenwirkende elektronische Komponente
- 10a: Chopper für Bremswiderstand
- 10b: Sanftanlaufeinrichtung (soft start device) für Umrichter
- 20: Spannungsverlaufsauswertevorrichtung
- 21: Gleichspannungsüberwachungseinheit
- 30: Steuerungs-/Regelungseinrichtung
- 40: elektrotechnische Schaltungsanordnung
- 100: Aufzugsystem
- 101: Aufzugskabine
- Sf: Fehlersignal
- Sc: Steuersignal
- S1: wiederkehrendes Aktivieren oder Abschalten wenigstens einer im/mit dem Bremswiderstandskreis (zusammen-)wirkenden elektronischen Komponente
- S2: Spannungsmonitoring durch Spannungsverlaufsauswertung
- S2a: Fehler diagnostizieren bei nicht erfolgendem Spanungsabfall im Zwischenkreis in Reaktion auf Aktivieren des Choppers
- S2b: Fehler diagnostizieren bei erfolgendem Spanungsabfall im Zwischenkreis in Reaktion auf Abschalten der Sanftanlaufeinrichtung
- S3: Generieren eines Fehlersignals
- S4: (Ab-)Schalten wenigstens einer antriebsbezogenen Komponente

## Patentansprüche

1. Verfahren zur Umrichterüberwachung bezüglich der Funktionsweise eines Bremswiderstandskreises (1) eines Aufzugsystems (100) umfassend wenigstens eine Aufzugskabine (101) und wenigstens einen Umrichter (2) und wenigstens einen Motor (3), der über den Umrichter mit Zwischenkreis (5) mit wenigstens einem Bremswiderstand (4) verschaltet ist, wobei ein Spannungsmonitoring zum Erkennen von Spannungsänderungen erfolgt;
**dadurch gekennzeichnet, dass** zur Umrichterüberwachung ein wiederkehrendes Aktivieren und/oder Abschalten wenigstens einer im Bremswiderstandskreis (1) wirkenden oder mit dem Bremswiderstandskreis (1) zusammenwirkenden elektronischen Komponente (10, 10a, 10b) erfolgt, wobei das Spannungsmonitoring bezüglich des Bremswiderstandskreises (1) in Abhängigkeit vom Aktivieren und/oder Abschalten erfolgt, wobei durch Auswertung des sich in Reaktion auf das Aktivieren und/oder Abschalten der wenigstens einen elektronischen Komponente (10) einstellenden Verlaufs der Spannung wenigstens ein fehlerhafter Betriebszustand erkannt oder wenigstens ein ordnungsgemäßer Betriebszustand festgestellt wird.

2. Verfahren nach dem vorhergehenden Verfahrensanspruch, wobei beim Aktivieren oder Abschalten einer ersten elektronischen Komponente ein in Reaktion darauf nicht erfolgender Spanungsabfall als Fehler diagnostiziert/definiert wird, und/oder wobei beim Aktivieren oder Abschalten einer zweiten elektronischen Komponente ein in Reaktion darauf erfolgender Spanungsabfall als Fehler diagnostiziert/definiert wird.

3. Verfahren nach dem vorhergehenden Verfahrensanspruch, wobei die erste elektronische Komponente ein Chopper-Transistor ist, welcher wiederkehrend aktiviert wird, insbesondere für einige Millisekunden im Leerlauf; und/oder die zweite elektronische Komponente eine Sanftanlaufeinrichtung des wenigstens einen Umrichters ist, welche wiederkehrend abgeschaltet wird, insbesondere für einige Millisekunden im Leerlauf.

4. Verfahren nach einem der vorhergehenden Verfahrensansprüche, wobei das Aktivieren oder Abschalten jeweils für einige Millisekunden im Leerlauf erfolgt.

5. Verfahren nach einem der vorhergehenden Verfahrensansprüche, wobei das Spannungsmonitoring eine Gleichspannungsüberwachung umfasst.

6. Verfahren nach einem der vorhergehenden Verfahrensansprüche, wobei durch Auswertung des Verlaufs der Spannung wenigstens ein fehlerhafter Betriebszustand aus der folgenden Gruppe festgestellt wird und ein damit korreliertes Fehlersignal generiert wird: dauerhaft leitender Chopper insbesondere aufgrund von fehlerhaftem Chopper-Treiber oder eines Kurzschlusses im Chopper, Erdschluss in der Verbindung zwischen Chopper und Bremswiderstand, Erdschluss im Bremswiderstand.

7. Verfahren nach einem der vorhergehenden Verfahrensansprüche, wobei eine vordefinierte Spannungsänderung derart mit einer Änderung der Temperatur des Bremswiderstands korreliert ist, dass eine indirekte Überwachung der Temperatur zumindest des Bremswiderstands durch Korrelation mit der gemessenen Spannungsänderungen detektierbar ist.

8. Verfahren zum Steuern/Regeln eines Aufzugsystems (100) basierend auf einem Verfahren zur Umrichterüberwachung nach einem der vorhergehenden Verfahrensansprüche, wobei das Aufzugsystem (100) oder zumindest wenigstens eine Aufzugskabine (101) des Aufzugsystems oder eine antriebsbezogene Komponente betreffend wenigstens eine Aufzugskabine des Aufzugsystems in Reaktion auf ein Diagnostizieren/Definieren des wenigstens einen Fehlers geschaltet wird, insbesondere mittels einer Steuerungs-/Regelungseinrichtung (30) des Aufzugsystems.

9. Verfahren nach dem vorhergehenden Anspruch, wobei das Verfahren bei weiterhin eingeschaltetem Umrichter (2) und bereits ausgeschaltetem Motor (3) ausgeführt wird, wobei das Ausschalten derart erfolgt, dass ein Dauerstrom im Bremswiderstand vermieden wird.

10. Computerprogrammprodukt umfassend Befehle, die bei Ausführung des Computerprogrammproduktes auf einem Computer diesen dazu veranlassen, ein Verfahren nach einem der vorhergehenden Verfahrensansprüche auf dem Computer auszuführen, insbesondere Computerprogrammprodukt eingerichtet zum Generieren einer Steuerungs-/Regelungsvorgabe für ein/das Aufzugsystem (100) in Abhängigkeit vom Diagnostizieren wenigstens eines Fehlers im Bremswiderstandskreis.

11. Verwendung einer elektrotechnischen Schaltungsanordnung (40) eingerichtet zum wiederkehrenden Aktivieren und/oder Schalten wenigstens einer mit einem Bremswiderstandskreis (1) eines Aufzugsystems (100) interagierenden oder im Bremswiderstandskreis wirkenden elektronischen Komponente (10, 10a, 10b) aus der Gruppe Chopper (10a) und Sanftanlaufeinrichtung (10b) zum Überwachen der Funktionsweise eines/des Bremswiderstandskreises (1) des Aufzugsystems (100), wobei ein Spannungsmonitoring bezüglich des Bremswiderstandskreises in Abhängigkeit vom Aktivieren und/oder Schalten erfolgt, wobei durch Auswerten des sich in Reaktion auf das Aktivieren und/oder Schalten der wenigstens einen elektronischen Komponente (10) einstellenden Verlaufs der Spannung wenigstens ein fehlerhafter Betriebszustand erkannt oder wenigstens ein ordnungsgemäßer Betriebszustand festgestellt wird, insbesondere bei einem Verfahren nach einem der vorhergehenden Verfahrensansprüche.

12. Spannungsverlaufsauswertevorrichtung (20) eingerichtet zur Umrichterüberwachung bezüglich der Funktionsweise eines Bremswiderstandskreises (1) eines Aufzugsystems (100) umfassend wenigstens eine Aufzugskabine (101) und wenigstens einen Umrichter (2) und wenigstens einen Motor (3), der über einen Zwischenkreis (5) mit wenigstens einem Bremswiderstand (4) verschaltet ist, wobei ein Spannungsmonitoring zum Erkennen von Spannungsänderungen erfolgt; wobei die Spannungsverlaufsauswertevorrichtung (20) eingerichtet ist, ein Spannungsmonitoring in Abhängigkeit von wiederkehrendem, bevorzugt regelmäßigem Aktivieren und/oder Abschalten wenigstens einer im Bremswiderstandskreis wirkenden oder mit dem Bremswiderstandskreis zusammenwirkenden elektronischen Komponente (10) vorzunehmen, insbesondere bei wiederkehrendem Aktivieren und/oder (An-/Ab-)Schalten durchgeführt mittels einer elektrotechnischen Schaltungsanordnung, wobei die Spannungsverlaufsauswertevorrichtung (20) eingerichtet ist zum Erkennen wenigstens eines fehlerhaften Betriebszustands oder zum Feststellen wenigstens eines ordnungsgemäßen Betriebszustands durch Auswertung des Verlaufs der Spannung, insbesondere Spannungsverlaufsauswertevorrichtung eingerichtet zum Ausführen eines Verfahrens zur Umrichterüberwachung nach einem der Verfahrensansprüche 1 bis 9.

13. Spannungsverlaufsauswertevorrichtung nach dem vorhergehenden Anspruch, wobei die elektrotechnische Schaltungsanordnung wenigstens eine erste elektronische Komponente in Ausgestaltung als Chopper-Transistor aufweist, welcher wiederkehrend aktivierbar ist, insbesondere für einige Millisekunden im Leerlauf; und/oder wobei die elektrotechnische Schaltungsanordnung wenigstens eine zweite elektronische Komponente in Ausgestaltung als Sanftanlaufeinrichtung des wenigstens einen Umrichters aufweist, welche wiederkehrend abschaltbar ist, insbesondere für einige Millisekunden im Leerlauf.

14. Spannungsverlaufsauswertevorrichtung nach einem der vorhergehenden Vorrichtungsansprüche 12, 13, wobei das wiederkehrende Aktivieren und/oder (An-/Ab-)Schalten derart durchführbar ist, dass beim Aktivieren oder Abschalten einer/der ersten elektronischen Komponente ein in Reaktion darauf nicht erfolgender Spanungsabfall als Fehler diagnostizierbar ist, und/oder wobei das wiederkehrende Aktivieren oder Abschalten einer/der zweiten elektronischen Komponente derart durchführbar ist, dass ein in Reaktion darauf erfolgender Spanungsabfall als Fehler diagnostizierbar ist.

15. Aufzugsystem (100) umfassend eine Spannungsverlaufsauswertevorrichtung (20) nach einem der vorhergehenden Vorrichtungsansprüche 12 bis 14, wobei das Aufzugsystem wenigstens eine Aufzugskabine (101) und wenigstens einen Umrichter (2) und wenigstens einen Motor (3) umfasst, der über den Umrichter mit Zwischenkreis (5) mit wenigstens einem Bremswiderstand (4) des Aufzugsystems verschaltet ist.
